# EUROPEAN PATENT APPLICATION

(11) **EP 1 102 404 A2**
(43) Date of publication of application: **23.05.2001**
(21) Application number: 00125122.2
(22) Date of filing: 17.11.2000
(51) Int. Cl.: H03M 1/18

(54) **Analog-to-digital converter, microcomputer, and analog-to-digital conversion method**

(30) Priority: 22.11.1999 JP 33118099
(71) Applicant: NEC CORPORATION, Tokyo (JP)
(72) Inventor: Tanaka, Mizue, NEC IC Microcomputer Systems, Ltd., Kawasaki-shi, Kanagawa (JP)
(74) Representative: Glawe, Delfs, Moll & Partner

(57) **Abstract**

An AD converter is of a construction that includes: an input terminal selection means for selecting a desired analog input terminal from among a plurality of analog input terminals that receive analog signals and outputting the analog signal that is received at that analog input terminal; a reference voltage control means for outputting a reference voltage control signal for selecting a desired reference voltage; a reference voltage switching means for selecting, in accordance with a reference voltage control signal, a desired reference voltage signal from among a plurality of reference voltage signals that are provided from the outside; a serial resistance string that includes a plurality of resistors connected in a series and that generates comparison voltages that are used for comparison with analog signals; a comparator for comparing a selected analog signal with comparison voltages; a sequential conversion register for temporarily saving the comparison results of the comparator; and a conversion result register for regulating the timing of the data of the sequential conversion register and outputting to the outside.

## Description

### Background of the Invention

### 1. Field of the Invention:

The present invention relates to an analog-to-digital converter having a plurality of analog input terminals, and particularly to an analog-to-digital converter that is used in cases in which the voltage ranges of received signals differ for each analog input terminal, a microcomputer that incorporates such an analog-to-digital converter, and an analog-to-digital conversion method.

### 2. Description of the Related Art:

In measuring instruments and other electronic devices, accurate measurement of the output of each type of sensor is essential. In cases in which the output of devices such as sensors is an analog signal, this signal may be converted to a digital signal for the purpose of displaying or saving the value. Analog-to-digital conversion (hereinbelow abbreviated as "AD conversion") is performed to convert an analog signal to a digital signal. Analog-to-digital converters (hereinbelow abbreviated as "AD converters") are used for this AD conversion.

In an AD converter, a reference voltage that is established according to the maximum value of analog signals is set for use in quantizing analog signals. The AD converter performs AD conversion by comparing a received analog signal with a plurality of comparison voltages that are obtained by voltage-dividing this reference voltage. Since the current trend is toward increase in the processing speed of electronic devices and instruments, AD converters must also be capable of high-speed operation.

In addition, AD converters that have a plurality of analog input terminals and that perform AD conversion by switching in time divisions are also used to reduce the circuit scale of measuring instruments and other electronic devices. This switching may be performed in accordance with the instructions of software in a microcomputer that incorporates an AD converter.

Alternatively, since software processing imposes limitations on speed, a scan mode is also known in which the selection of analog input terminals is switched automatically by hardware.

Analog signals include signals produced by a plurality of power source systems, such as signals produced by a 3-V power source system, signals produced by a 5-V power supply system; and a plurality of analog signals having differing peak voltages may therefore be mixed and used within one device or system. In such cases, it is preferable that a single AD converter be capable of performing AD conversion of a plurality of analog signals having different peak voltages.

As a prior-art AD conversion method in which a plurality of analog signals having different peak voltages undergo AD conversion by a single AD converter, AD conversion of all analog signals is performed by using a reference voltage that is appropriate to the analog signal having the highest peak voltage so as to enable AD conversion of all analog signals by the same reference voltage.

According to another method that can be considered, the reference voltage of the AD converter is switched in accordance with the switching of input signals according to instructions from a processor.

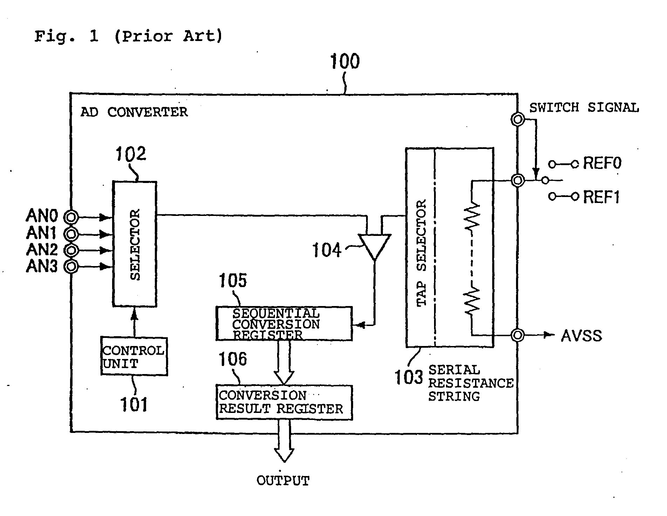

Referring now to Fig. 1, a schematic block diagram shows the construction of a prior-art AD converter of the sequential comparison type that can switch reference voltages in accordance with processing by a processor.

AD converter 100 comprises: selector 102 for selecting a prescribed input signal from input signals AN0^{~}3; control unit 101 for instructing the selection of selector 102; serial resistance string 103 for generating, by a plurality of resistors connected in a series, comparison voltages that are compared with input signals; comparator 104 for comparing analog signals with comparison voltages; sequential conversion register 105 for temporarily saving the results of comparison of comparator 104; and conversion result register 106 for regulating the timing of the data of sequential conversion register 105 and outputting to the outside.

A processor (not shown in the figure) outputs switch signals for selecting reference signals REFO and REF1 based on the selection of selector 102, whereby a reference voltage appropriate for each input signal is applied to serial -resistance string 103.

An example is next shown of the AD conversion operation by serial resistance string 103, which includes a tap selector; comparator 104; sequential conversion register 105; and conversion result register 106.

First, prescribed voltages from among the plurality of comparison voltages, which are obtained by dividing the reference voltage by means of the plurality of resistors of serial resistance string 103, are sequentially selected and outputted by the tap selector. At comparator 104, the voltage of an analog signal is sequentially compared with comparison voltages that are outputted from the tap selector. Based on the results of this comparison, the comparison voltage having the voltage that is closest to the analog signal is saved in conversion result register 106 as the result of analog-to-digital conversion. The order of selection of comparison voltages by the tap selector is typically binary.

In a case in which a plurality of analog signals having different peak voltages undergo AD conversion by a single AD converter, a method that uses the reference voltage that is appropriate to the analog signal having the highest peak voltage for all analog signals suffers from the problem that, for analog signals having low peak voltages, AD conversion of an accuracy that is appropriate to the number of bits provided for quantizing is not possible, i.e., the level of error is excessive.

Moreover, a method in which reference voltages are switched by the processing of a processor suffers from the problem that the execution of switching operations by a processor places a great burden on the processor, and this burden is disadvantageous for an AD converter that must also realize high-speed operation.

Finally, in the scan mode, since switching of analog signals is performed without the interposition of a processor, the processor does not obtain the selected input signals and cannot instruct switching of reference voltages.

### SUMMARY OF THE INVENTION

The present invention was achieved with the aim of solving the above-described problems of the prior art, and has as an object the provision of: an AD converter having a plurality of analog input terminals that is adapted for cases in which the voltage ranges of received signals differ for each analog input terminal, a microcomputer that incorporates such an AD converter, and an AD conversion method.

The analog-to-digital converter of the present invention for achieving the above-described object is an analog-to-digital converter that selects a prescribed analog signal from a plurality of received analog signals and performs analog-to-digital conversion of the selected analog signal; and comprises:
an input terminal selection means for selecting a prescribed analog input terminal from among a plurality of analog input terminals and outputting the analog signal that has been received at the selected analog input terminal;
a reference voltage switching means that is capable of selecting a prescribed reference voltage from among a plurality of reference voltages; and
a reference voltage control means for instructing the reference voltage switching means to select the reference voltage that is appropriate to the analog signal that is received at the analog input terminal that was selected by the input terminal selection means.

The input terminal selection means may sequentially switch the selection of the analog input terminals in time divisions in accordance with a prescribed setting.

In addition, the reference voltage switching means may allow setting of the plurality of reference voltages from the outside.

Further, the reference voltage control means may include a reference voltage setting means that allows setting, from the outside, of the correspondence between the analog input terminals and the reference voltages that are appropriate to the analog signals that are received at the analog input terminals.

An analog-to-digital converter as described hereinabove is capable of analog-to-digital conversion using the reference voltages that are appropriate to each of the analog signals of the various analog input terminals, and therefore is capable of converting analog signals having a low peak voltage with a low level of error.

In addition, high-speed analog-to-digital conversion is possible because the reference voltages can be switched automatically using hardware.

Furthermore, a burden is not placed on the processor because the reference voltages can be switched without the interposition of software processing by a processor.

Still further, the present invention can be used in measuring instruments for a variety of purposes and other electronic devices because a plurality of reference voltages can be provided from the outside.

The microcomputer according to the present invention selects a prescribed analog signal from among a plurality of received analog signals and performs analog-to-digital conversion of the selected analog signal; and comprises:
the above-described analog-to-digital converter; a processor for: setting, in the input terminal selection means, analog input terminals that are to be sequentially selected in time divisions; setting, in the control means, the correspondence between the analog input terminals and the reference voltages that are appropriate to analog signals that are received at the analog input terminals; and instructing the analog-to-digital converter to begin the analog-to-digital conversion; and
memory for recording a program for causing the processor to execute the settings and the instructions to the above-described analog-to-digital converter. Accordingly, the microcomputer of the present invention produces the same effects as the above-described analog-to-digital converter.

The analog-to-digital conversion method of the present invention is for sequentially selecting a prescribed analog signal from among a plurality of analog signals and performing analog-to-digital conversion, and comprises the steps of:
providing a reference voltage setting means for setting in advance reference voltages that are appropriate to each of the plurality of analog signals;
   setting, in the reference voltage setting means, reference voltages that are appropriate to each of the analog signals;
sequentially selecting a prescribed analog signal from among the plurality of analog signals;
   determining the reference voltage that is appropriate to the selected analog signal based on the reference voltage setting means;
voltage-dividing the reference voltage that is obtained by the above-described determination to generate a plurality of comparison voltages; and
   sequentially comparing the plurality of comparison voltages and the voltage of said selected analog signal and detecting the comparison voltage that is closest to the voltage of said analog signal.

The analog-to-digital conversion method of the present invention thus enables analog-to-digital conversion using a reference voltage that is appropriate to each of the analog signals, thereby enabling conversion of analog signals having a low peak voltage with little error.

In addition, the present invention can be used for a variety of purposes because a plurality of reference voltages can be applied from the outside.

The above and other objects, features, and advantages of the present invention will become apparent from the following description based on the accompanying drawings which illustrate examples of preferred embodiments of the present invention.

### BRIEF DESCRIPTION OF THE DRAWINGS

Fig. 1 is a schematic block diagram showing the construction of a prior-art analog-to-digital converter of the sequential comparison type that is capable of switching reference voltages by means of the processing of a processor;
Fig. 2 is a schematic block diagram showing the construction of the analog-to-digital converter of the present invention;
Fig. 3 is a view of the register structure showing an example of the settings of reference voltage setting register 71.
Fig. 4 is a timing chart for explaining the operation of analog-to-digital converter 10; and
Fig. 5 is a schematic block diagram showing an example of the construction of a microcomputer that incorporates the analog-to-digital converter of the present invention.

### DETAILED DESCRIPTION OF THE PREFERRED EMBODIMENTS

Referring now to the drawings, the embodiments of the analog-to-digital converter of the present invention are next explained in detail.

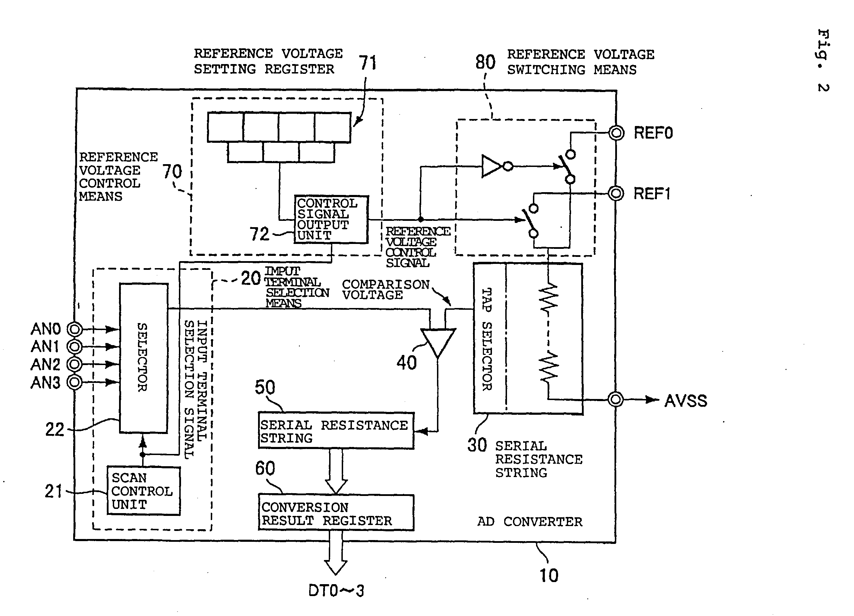

Fig. 2 is a schematic block diagram showing the construction of the analog-to-digital converter of the present invention.

In Fig. 2, analog-to-digital converter 10 is a construction that comprises: input terminal selection means 20 that selects a prescribed analog input terminal from among a plurality of analog input terminals AN0^{~}AN3 to which analog signals are applied and that outputs the analog signal that is received at that analog input terminal; reference voltage control means 70 that outputs reference voltage control signals for selecting a desired reference voltage; reference voltage switching means 80 that, in accordance with a reference voltage control signal, selects a desired reference voltage signal from a plurality of reference voltage signals REFO and REF1 that are provided from the outside; serial resistance string 30 that has a plurality of resistors connected in a series and that generates comparison voltages that are used for comparison with analog signals; comparator 40 that compares a selected analog signal with comparison voltages; sequential conversion register 50 that temporarily saves the comparison result of comparator 40; and conversion result register 60 that regulates timing of data of sequential conversion register 50 and outputs to the outside.

A memory (not shown in the drawings) and a processor (not shown in the drawings) for executing the setting and control of AD converter 10 are provided outside AD converter 10.

In this example, input terminal selection means 20 includes: scan control unit 21 that outputs input terminal selection signals for selecting analog input terminals based on scan information by which analog input terminals, which are switched and selected in time divisions, are set; and selector 22 that selects a desired analog input terminal from among analog input terminals AN0^{~}AN3 based on input terminal selection signals.

In addition, reference voltage control means 70 is of a construction that includes: reference voltage setting register 71 that allows setting of the reference voltages that are appropriate to each of analog input terminals AN0^{~}AN3 by an outside processor; and control signal output unit 72 that determines the reference voltage signal that is appropriate to a selected analog signal based on reference voltage setting register 71 and outputs a reference voltage control signal for selecting a reference voltage signal.

The operation of AD converter 10 of the present invention is next described.

First, reference voltage signals REF0 and REF1 of reference voltages VREF0 and VREF1, respectively, are supplied from the outside to reference voltage switching means 80. In addition, prescribed scan information is supplied to scan control unit 21, and prescribed values are recorded in reference voltage setting register 71.

Scan control unit 21 outputs input terminal selection signals based on the scan information. Selector 22 selects one analog input terminal from among analog input terminals AN0^{~}AN3 in accordance with the input terminal selection signals, and outputs the analog signal of the selected terminal. Control signal output unit 72 selects the reference voltage signal that corresponds to the selected analog input terminal based on reference voltage setting register 71 and outputs this selection result as the reference voltage control signal.

Reference voltage switching means 80 selects the desired reference voltage signal based on the reference voltage control signal and outputs to serial resistance string 30. Serial resistance string 30 outputs comparison voltages using the provided reference voltage signal. The voltage of the signal that is outputted from selector 22 is compared with the comparison voltages that are outputted from serial resistance string 30 at comparator 40, and the comparison results are temporarily saved in sequential conversion register 50.

The information that is saved in sequential conversion register 50 undergoes timing regulation and is transferred to conversion result register 60. Conversion result register 60 outputs the information that is saved inside as the results of AD conversion.

Scan control unit 21 switches the selection of analog input terminals in time divisions based on scan information and the above-described operation of AD converter 10 is repeated.

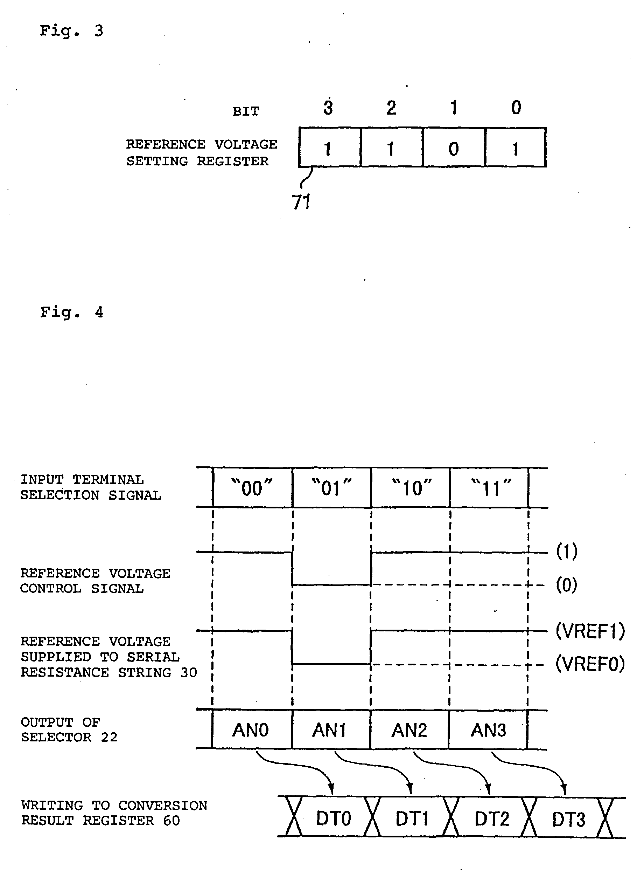

Next, an example of the content of reference voltage setting register 71 and scan information is shown in Fig. 3, and the operation of AD converter 10 is further described using Fig. 4.

Fig. 3 is a register structure view showing an example of the settings of reference voltage setting register 71.

Fig. 4 is a timing chart for explaining the operation of AD converter 10.

In this case, the scan information is set such that analog input terminals are selected in the order of AN0, AN1, AN2, and AN3, this selection being repeated cyclically. In addition, the output signals, which are the result of subjecting the analog signals of analog input terminals AN0^{~}AN3 to AD conversion, are identified as DT0^{~}DT3, respectively.

In Fig. 3, bits 0^{~}3 of reference voltage setting register 71 indicate the reference voltages that correspond to analog input terminals AN0^{~}AN3, respectively. Accordingly, reference voltage signal REF1 corresponds to analog input terminals AN0, AN2, and AN3, and reference voltage signal REF0 corresponds to analog input terminal AN1.

In Fig. 4, the input terminal selection signals that are represented by two bits in this embodiment sequentially take the values "00," "01," "10," and "11," and the analog input terminals are therefore selected in the order AN0, AN1, AN2, and AN3. In accordance with this selection, the reference voltage control signals are outputted as "1," "0," "1," and "1." The reference voltages are sequentially supplied to serial resistance string 30 as VREF1, VREF0, VREF1, and VREF1. In serial resistance string 30, comparison voltages are generated and outputted based on the reference voltage, and the output of selector 22 thus undergoes AD conversion by being compared with comparison voltages that have been generated using the respectively appropriate reference voltage. Output signals DT0, DT1, DT2, and DT3, which are the results of AD conversion, are sequentially outputted from conversion result register 60.

Since AD conversion can be performed using reference voltages that are appropriate to each of the analog signals of analog input terminals AN0^{~}AN3, analog signals having low peak voltages can be AD converted with little error, and the present invention can therefore be applied for purposes in which high accuracy is demanded.

In addition, since reference voltages VREF0 and VREF1 can be automatically switched by means of hardware, high-speed AD conversion is possible, and the present invention can be applied for purposes in which high-speed processing is demanded.

Furthermore, since switching of the reference voltage can be effected without the interposition of software processing by a processor outside AD converter 10, no burden is placed on the processor, and a greater number of other processes can be executed by software.

Moreover, since a plurality of reference voltages VREF0 and VREF1 can be provided from the outside, the present invention has a still greater range of application and can be used in measuring instruments for a variety of purposes and other electronic devices.

In addition, a plurality of conversion result registers 60 can be provided in correspondence with each of analog input terminals AN0^{~}AN3.

In this case, the results of AD conversion using reference voltages that are appropriate for each of the input signals of analog input terminals AN0^{~}AN3 are each outputted to a corresponding conversion result register. As a result, the results can be easily distinguished by address and the burden placed on the processor can be further lightened.

An embodiment of a microcomputer that incorporates the AD converter of this invention is next described with reference to the drawings.

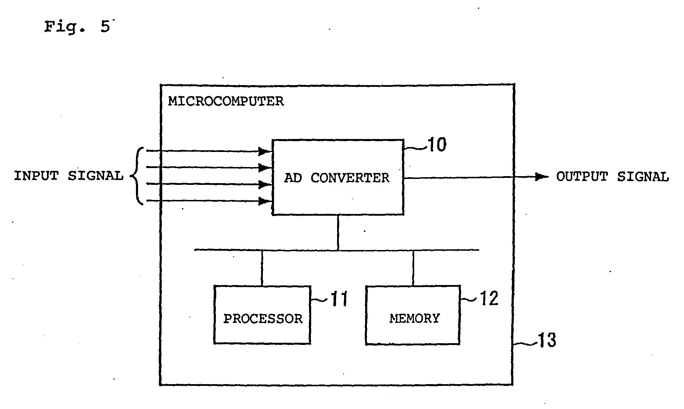

Fig. 5 is a schematic block diagram showing an example of the construction of a microcomputer that incorporates the AD converter of the present invention.

In Fig. 5, microcomputer 13 is of a structure that includes: the above-described AD converter 10; processor 11 that sets in input terminal selection means 20 analog input terminals AN0^{~}AN3 that are selected in time divisions, sets in reference voltage control means 70 the correspondence between analog input terminals AN0^{~}AN3 and reference voltage signals REF0 and REF1, and instructs AD converter 10 to start AD conversion; and memory 12 in which is recorded a program necessary for setting and instructing AD converter 10.

The operation of microcomputer 13 of this invention is next described.

Processor 11 first reads a program that is recorded in memory 12, and executes processing to set analog input terminals AN0^{~}AN3 that are selected in time divisions in input terminal selection means 20, and to set the correspondence between analog input terminals AN0^{~}AN3 and reference voltage signals REF0 and REF1 in reference voltage control means 70. Processor 11 then instructs AD converter 10 to begin AD conversion. AD converter 10 performs sequential switching and AD conversion of signals that are received at analog input terminals AN0~AN3 in accordance with the settings, and outputs the result.

The present invention enables analog-to-digital conversion using reference voltages that are appropriate to each of the analog signals of the analog input terminals, thereby enabling analog-to-digital conversion of analog signals having a low peak voltage with little error and enabling the use of the invention for purposes requiring high accuracy.

In addition, since the reference voltages can be switched automatically by means of hardware, the present invention allows high-speed analog-to-digital conversion and can be used for purposes requiring high-speed processing.

Furthermore, since the reference voltages can be switched without the interposition of software processing by a processor, the present invention places no burden on the processor and allows the execution of additional other processing by software.

Finally, since a plurality of reference voltages can be provided from the outside, the present invention has a wide range of application and can be used in measuring instruments for a variety of uses and other electronic devices.

While preferred embodiments of the present invention have been described using specific terms, such description is for illustrative purposes only, and it is to be understood that changes and variations may be made without departing from the spirit or scope of the following claims.

## Claims

1. An analog-to-digital converter that selects a prescribed analog signal from among a plurality of received analog signals and performs analog-to-digital conversion of the selected analog signal; comprising:
an input terminal selection means for selecting a prescribed analog input terminal from among a plurality of analog input terminals and outputting said analog signal that has been received at the selected analog input terminal;
a reference voltage switching means that is capable of selecting a prescribed reference voltage from among a plurality of reference voltages; and
a reference voltage control means for instructing said reference voltage switching means to select said reference voltage that is appropriate to the analog signal that is received at said analog input terminal that was selected by said input terminal selection means.

2. An analog-to-digital converter according to claim 1 wherein said input terminal selection means sequentially switches the selection of said analog input terminals in time divisions in accordance with a prescribed setting.

3. An analog-to-digital converter according to claim 1 wherein said reference voltage switching means allows setting of said plurality of reference voltages from an outside.

4. An analog-to-digital converter according to claim 2 wherein said reference voltage switching means allows setting of said plurality of reference voltages from an outside.

5. An analog-to-digital converter according to claim 1 wherein said reference voltage control means comprises:
a reference voltage setting means that allows setting, from an outside, of a correspondence between said analog input terminals and said reference voltages that are appropriate to said analog signals that are received at said analog input terminals.

6. An analog-to-digital converter according to claim 2 wherein said reference voltage control means comprises:
a reference voltage setting means that allows setting, from an outside, of a correspondence between said analog input terminals and said reference voltages that are appropriate to said analog signals that are received at said analog input terminals.

7. An analog-to-digital converter according to claim 3 wherein said reference voltage control means comprises:
a reference voltage setting means that allows setting, from an outside, of a correspondence between said analog input terminals and said reference voltages that are appropriate to said analog signals that are received at said analog input terminals.

8. An analog-to-digital converter according to claim 4 wherein said reference voltage control means comprises:
a reference voltage setting means that allows setting, from an outside, of a correspondence between said analog input terminals and said reference voltages that are appropriate to said analog signals that are received at said analog input terminals.

9. A microcomputer that selects a prescribed analog signal from among a plurality of received analog signals and performs analog-to-digital conversion of the selected analog signal; comprising:
an analog-to-digital converter according to claim 5, 6, 7 or 8
a processor for: setting, in said input terminal selection means, analog input terminals that are to be sequentially selected in time divisions; setting, in said reference voltage control means, the correspondence between said analog input terminals and reference voltages that are appropriate to analog signals that are received at said analog input terminals; and instructing said analog-to-digital converter to begin said analog-to-digital conversion; and
memory for recording a program for causing said processor to execute the settings and the instructions to said analog-to-digital converter.

10. An analog-to-digital conversion method for sequentially selecting a prescribed analog signal from among a plurality of analog signals and performing analog-to-digital conversion, comprising the steps of:
providing a reference voltage setting means for setting in advance reference voltages that are appropriate to each of a plurality of said analog signals;
setting, in said reference voltage setting means, reference voltages that are appropriate to each of said analog signals;
sequentially selecting a prescribed analog signal from among said plurality of analog signals;
determining said reference voltage that is appropriate to said selected analog signal based on said reference voltage setting means;
voltage-dividing said reference voltage that is obtained by said determination to generate a plurality of comparison voltages; and
sequentially comparing said plurality of comparison voltages and a voltage of said selected analog signal and detecting said comparison voltage that is closest to the voltage of said analog signal.
